# EUROPÄISCHE PATENTSCHRIFT

(11) **EP 1 727 414 B1**
(45) Veröffentlichungstag und Bekanntmachung des Hinweises auf die Patenterteilung: **02.07.2008**
(21) Anmeldenummer: 06113370.8
(22) Anmeldetag: 02.05.2006
(51) Int. Cl.: H05K 13/04

(54) **Zuführeinrichtung für elektrische Bauteile und zugehöriges Steuerverfahren**
Feeding apparatus for electrical components and corresponding control method
Dispositif d'alimentation pour composants électriques et procédé de commande correspondant

(30) Priorität: 23.05.2005 DE 102005023704
(43) Veröffentlichungstag der Anmeldung: 29.11.2006
(73) Patentinhaber: SIEMENS AKTIENGESELLSCHAFT, 80333 München (DE)
(72) Erfinder: Worzischek, Alexander, 82061 Neuried (DE)

(56) Entgegenhaltungen:
- DE-A1- 4 021 101
- DE-A1- 10 135 289
- US-A- 5 191 693
- PATENT ABSTRACTS OF JAPAN Bd. 2003, Nr. 05, 12. Mai 2003 (2003-05-12) & JP 2003 031998 A (JUKI CORP), 31. Januar 2003 (2003-01-31)

## Beschreibung

Die Erfindung betrifft eine Zuführeinrichtung für elektrische Bauteile, welche in einem Bauteilgurt angeordnet sind, mit einer Abzugseinrichtung für eine Deckfolie des Bauteilgurts und einem Spannelement zum Spannen der abgezogenen Deckfolie, wobei das Spannelement relativ zu einem Gehäuse der Zuführeinrichtung beweglich gelagert und beim Fehlen der Deckfolie eine Endlage einnimmt. Ferner betrifft die Erfindung ein zugehöriges Steuerverfahren sowie ein Steuerverfahren.

Die Patentschrift US-A-5 191 693 offenbart eine Zuführeinrichtung nach dem Oberbegriff des Anspruchs 1.

Aus der Offenlegungsschrift EP-0859543 ist eine Zuführeinrichtung bekannt, bei der ein Bauteilgurt mittels eines Transportrads zu einer Entnahmestelle befördert wird, an der die Bauteile entnommen werden. Der Bauteilgurt besteht aus einem mit Taschen für die Bauteile versehenen Trägerband, welches durch ein Abdeckband verschlossen ist. Das Abdeckband wird vor der Entnahmestelle mittels einer Abziehvorrichtung abgezogen.

In der Patentschrift DE-4021101 ist eine Abzugseinrichtung für die Deckfolie eines Bauelementegurtes offenbart, mit einer von einem Motor antreibbaren Rolle zum Aufwickeln der vom Bauelementegurt gelösten Deckfolie unter Aufbringung einer Abzugskraft und mit einer federbelasteten Schwinge, über die die auf die Rolle auflaufende Deckfolie geführt ist, wobei die Schwinge in Abhängigkeit von der auf sie einwirkenden Federkraft die Abzugskraft durch Ein- und Ausschalten des Motors über ein Schaltorgan einstellt.

Bei den aus dem Stand der Technik bekannten Zuführeinrichtungen wird das Auswechseln des Bauteilgurts manuell vom Bediener durchgeführt. Um eine Rückverfolgung der bestückten Bauelemente bis hin zum zugehörigen Bauteilgurt (traceablility) zu ermöglichen, muss der Bediener nach jedem Bauteilgurtwechsel dafür sorgen, dass der neu eingelegte Bauteilgurt in geeigneter Weise identifiziert wird. Wird die Identifizierung nicht durchgeführt, so bleibt dies in der Regel unbemerkt und es kommt zu falschen Rückverfolgungsdaten der bestückten Bauteile.

Es ist deshalb die Aufgabe der vorliegenden Erfindung, eine Zuführeinrichtung, ein zugehöriges Steuerverfahren sowie ein Steuerverfahren für ein Bestücksystem, welches eine derartige Zuführeinrichtung aufweist, zu liefern, bei der die Gefahr derartiger Fehlbedienungen verringert werden kann.

Diese Aufgabe wird durch die Zuführeinrichtung und das Steuerverfahren gemäß den unabhängigen Ansprüchen 1 und 6 gelöst.

Die Zuführeinrichtung für in einem Bauteilgurt angeordnete elektrische Bauteile gemäß dem Anspruch 1 umfasst eine Abzugseinrichtung für eine Deckfolie des Bauteilgurts, ein Spannelement zum Spannen der abgezogenen Deckfolie, wobei das Spannelement relativ zu einem Gehäuse der Zuführeinrichtung beweglich gelagert ist und bei Fehlen der Deckfolie erste Endlage einnimmt. Ferner weist die Zuführeinrichtung einen Sensor zum Erfassen der Position des Spannelements und eine Steuereinrichtung auf, welche mit dem Sensor verbunden ist und derart ausgebildet ist, dass sie basierend auf der vom Sensor erfassten Position des Spannelementes einen Fehlerzustand erkennt. Da eine Veränderung am Bauteilgurt, sei es ein Riss, ein Auslaufen oder ein Wechsel des Bauteilgurts über die Deckfolie immer auch eine Auswirkung auf die Position des Spannelements hat, wird eine derartige Veränderung von der Steuereinrichtung als Fehlerzustand sicher erkannt. In der Steuereinrichtung ist eine entsprechende Information über den Fehlerzustand generier- und abrufbar. Eine derartige Information kann beispielsweise dafür benutzt werden, um weitere Aktionen einzuleiten, wie beispielsweise einen Hinweis an den Maschinenbediener. Die Gefahr von Fehlbedienungen, welche zu falschen Rückverfolgungsdaten führen können, kann dadurch verhindert werden. Erfindungsgemäß kann die Steuereinrichtung nun durch Ermittlung der Position des üblicherweise schon vorhandenen Spannelements auf einen Fehlerzustand des Bauteilegurts schließen. Die Anzahl der zusätzlichen Bauelemente wird dadurch sehr klein gehalten.

Gemäß der erfindungsgemäßen Ausgestaltung der Zuführeinrichtung weist die Abzugseinrichtung einen Fördermechanismus mit einem Motor zum Transport der Deckfolie, und das Spannelement eine federbelastete Schwinge auf, über die die abgezogene Deckfolie führbar ist. Diese Ausgestaltung der Zuführeinrichtung zeichnet sich durch eine einfache und preiswerte mechanische Lösung des Spannelements aus.

Gemäß der Ausgestaltung nach Anspruch 2 ist die Steuereinrichtung derart ausgebildet, dass sie den Fehlerzustand dann erkennt, wenn sich das Spannelement in der Endlage befindet. Die Information über den Fehlerzustand ist unmittelbar nach der Einnahme der Endlage verfügbar und abrufbar. Diese Variante ist insbesondere dann von Vorteil, wenn ein Fehlerzustand möglichst früh erkannt werden soll.

In einer weiteren Ausgestaltung gemäß dem Anspruch 3 erkennt die Steuereinrichtung den Fehlerzustand genau dann, wenn sich das Spannelement für eine bestimmte vorgegebene Zeitdauer in der Endlage befindet. In bestimmten Situationen soll der Fehlerzustand nicht sofort bei Einnahme des Endlage erkannt werden sondern erst nach einer vorgegebenen Zeitspanne. Diese Variante ist dann sinnvoll, wenn ein Fördermechanismus für die Deckfolie zum Nachspannen der Deckfolie aktiviert wird, wenn das Spannelement die Endlage einnimmt.

Eine weitere Alternative für das Kriterium, wann die Steuereinrichtung den Fehlerzustand erkennt, ist in Anspruch 4 dargestellt. In diesem Fall nimmt das Spannelement bei gespannter Deckfolie eine bestimmte Spannposition ein, welche sich von der Endlage unterscheidet. Der Sensor ist derart ausgebildet, dass er zumindest die Spannposition und die Endlage erfasst. Die Steuereinrichtung erkennt den Fehlerzustand genau dann, wenn das Spannelement nach der Einnahme der Endlage nicht innerhalb einer vorgegebenen Zeit die Spannposition wieder einnimmt.

Die Zuführeinrichtung ist erfindungsgemäß auch dahingehend ausgestaltet, dass das Spannelement bei gespannter Deckfolie eine Spannposition einnimmt, welche sich von der Endlage unterscheidet, und der Motor des Fördermechanismus' mit der Steuereinrichtung verbunden ist. Die Steuereinrichtung erkennt den Fehlerzustand genau dann, wenn das Spannelement nach Einschalten des Motors nicht innerhalb einer vorgegebenen Zeitdauer die Spannposition einnimmt. Der Fördermechanismus dient dazu, die Deckfolie weiterzufördern und nachzuspannen. Der Motor des Fördermechanismus wird dazu in zeitlichen Abständen aktiviert, was von der Steuereinrichtung erkannt wird. Die Steuereinrichtung ist ferner so ausgebildet, dass sie die Zeitdauer ab Einschalten des Motors misst. Nimmt das Spannelement nach Einschalten des Motors nicht innerhalb einer bestimmten Zeitdauer die Spannposition ein, so schließt die Steuereinrichtung auf einen Fehlerzustand, wie beispielsweise auf das Auslaufen des Bauteilgurts.

Eine preiswerte und einfache Ausgestaltung der Zuführeinrichtung gemäß Anspruch 5 weist sich dadurch aus, dass der Sensor als Hall-Sensor ausgebildet ist.

Ein Steuerverfahren für eine erfindungsgemäße Zuführeinrichtung, welche zusätzlich ein mit der Steuereinrichtung verbundenes nichtflüchtiges Speicherelement aufweist, ist Gegenstand des Anspruchs 6. Das Verfahren zeichnet sich dadurch aus, dass die Steuereinrichtung vor jedem Abschalten der Zuführeinrichtung bzw. vor jeder Trennung der Zuführeinrichtung von der Spannungsquelle die Position des Spannelements in dem nichtflüchtigen Speicherelement abspeichert und nach dem darauf folgenden Einschalten der Zuführeinrichtung bzw. Verbinden der Zuführeinrichtung mit der Spannungsquelle die Position des Spannelements vor dem Abschalten mit der Position des Spannelements beim Einschalten der Zuführeinrichtung vergleicht. Erfindungsgemäß erkennt die Steuereinrichtung den Fehlerzustand dann, wenn sich die beiden Positionen unterscheiden. Gemäß diesem Verfahren ist es möglich, eine Manipulation des Bauteilgurts auch dann zu erkennen, wenn diese außerhalb eines Bestückautomaten bzw. im stromlosen Zustand der Zuführeinrichtung durchgeführt wurde. Beispielsweise kann es vorkommen, dass der Maschinenbediener die Zuführeinrichtung von einem Bestückautomaten entnimmt (und dadurch von der Spannungsquelle trennt), um den enthaltenen Bauteilgurt zu entnehmen und durch einen neuen zu ersetzen. Die letzte Position des Spannelements vor dem Abschalten wird dabei in dem Speicherelement abgespeichert. Jedoch muss der Bediener zum Spannen der Deckfolie die Zuführeinrichtung wieder mit einer Spannungsquelle verbinden. In diesem Moment erfasst der Sensor die Position des Spannelements unmittelbar nach dem Einschalten und vergleicht diese mit der Position des Spannelements vor dem Ausschalten. Ist der Bauteilgurt beispielsweise ausgetauscht worden, so unterscheiden sich die beiden Positionen voneinander, was von der Steuereinrichtung als Fehlerzustand erkannt wird.

Gemäß einer Ausgestaltung des Steuerverfahrens nach Anspruch 7 speichert die Steuereinrichtung den erfassten Fehlerzustand in dem Speicherelement ab. Sollte der Bauteilgurtwechsel außerhalb eines Bestückautomaten, beispielsweise in einer Rüstvorrichtung für die Steuereinrichtung vorgenommen worden sein, bleibt die Information über den Fehlerzustand in dem Speicherelement gespeichert, so dass sie auch beim Ankoppeln an den Bestückautomaten noch verfügbar ist.

Ein Steuerverfahren für eine Zuführeinrichtung, die an einen Bestückautomaten gekoppelt ist, ist Gegenstand des Anspruchs 8. Das Bestücksystem, auf welches das Steuerverfahren gerichtet ist, weist ferner eine Datenschnittstelle auf, über welche Daten zwischen der Steuereinrichtung der Zuführeinrichtung und einer dem Bestückautomaten zugeordneten Zentralsteuerung austauschbar sind. Das Steuerverfahren ist dadurch gekennzeichnet, dass die Steuereinrichtung der Zuführeinrichtung einen erfassten Fehlerzustand an die Zentralsteuerung des Bestückautomaten übermittelt. Dadurch wird gewährleistet, dass die Zentralsteuerung des Bestückautomaten von dem Fehlerzustand Kenntnis erlangt und entsprechende Aktionen einleiten kann.

Das Steuerverfahren kann gemäß Anspruch 9 dahingehend ausgestaltet werden, dass die Zentralsteuerung des Bestückautomaten den Fehlerzustand über eine Anzeigeeinrichtung dem Maschinenbediener mitteilt. Der Bediener kann manuell entsprechende Aktionen, wie beispielsweise die Identifizierung des neuen Bauteilgurts, vornehmen.

In einer Ausgestaltung des Steuerverfahrens nach Anspruch 10 prüft die Zentralsteuerung vor dem Abholen eines Bauteils von der Zuführeinrichtung mittels eines Bestückkopfes des Bestückautomaten, ob ein Fehlerzustand von der Steuereinrichtung erkannt wurde. Falls ein Fehlerzustand erkannt wurde, steuert die Zentralsteuerung den Bestückautomaten dann so, dass keine Bauteile von der Zuführeinrichtung abholt werden. Dadurch wird gewährleistet, dass, falls ein Fehlerzustand bzw. eine Veränderung am Bauteilgurt durch die Steuereinrichtung erfasst, keine Bauteile von dieser Zuführeinrichtung im Bestückprozess verwendet werden, um so einer fehlerhaften Rückverfolgung der Bauteile vorzubeugen.

Bei der Ausgestaltung des Steuerverfahrens nach Anspruch 11 ist der von der Zuführeinrichtung zu fördernde Bauteilgurt mittels einer ihm zugeordneten Markierung von einer Erfassungseinrichtung identifizierbar, wobei das Verfahren dadurch ausgezeichnet ist, dass der Bestückautomat erst dann wieder Bauteile von der Zuführeinrichtung abholt, wenn der Bauteilgurt von der Erfassungseinrichtung identifiziert wurde. Dadurch wird sichergestellt, dass im Bestückprozess nur Bauteile verwendet werden, deren Identität fehlerfrei bis zum zugehörigen Bauteilgurt zurückverfolgt werden kann.

In der Ausgestaltung des Steuerverfahrens nach Anspruch 12 ist die Erfassungseinrichtung an dem Bestückautomaten derart angeordnet, dass der Bauteilgurt, welcher in der Zuführeinrichtung eingelegt ist, identifizierbar ist, wobei sich das Verfahren dadurch auszeichnet, dass die Zentralsteuerung die Identifizierung des Bauteilgurts automatisch durchführt, wenn ein Fehlerzustand erkannt wurde. Durch diese Anordnung und dieses Verfahren muss die Identifizierung nicht mehr händisch durch den Bediener durchgeführt werden. Dadurch wird die Identifizierung verlässlich durchgeführt und die Rückverfolgung der Bauteile ist immer gewährleistet.

Im Folgenden wird ein vorteilhaftes Ausführungsbeispiel der erfindungsgemäßen Zuführeinrichtung und der erfindungsgemäßen Steuerverfahren mit Bezug auf die beigefügten Zeichnungen näher erläutert. In den Zeichnungen sind:
Figur 1 eine schematische Ansicht eines Bestücksystems mit einem Bestückautomaten und mehreren daran gekoppelten Zuführeinrichtungen;
Figur 2 eine schematische Querschnittsansicht eines Bauteilgurts;
Figur 3 und Figur 4 eine schematische Teilansicht einer erfindungsgemäßen Zuführeinrichtung bei gespannter und bei fehlender Deckfolie.

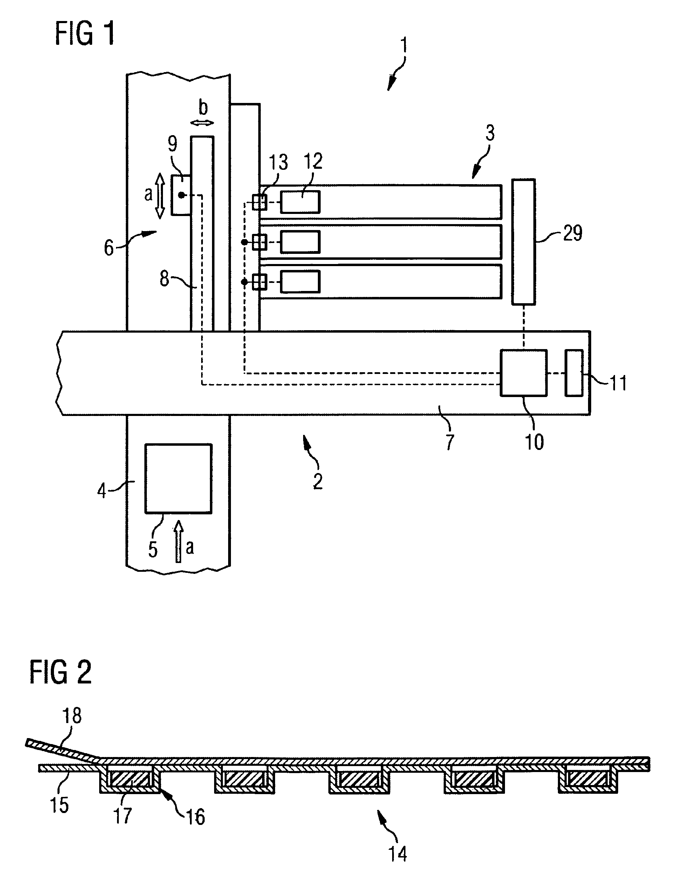

In Figur 1 ist schematisch ein Bestücksystem 1 dargestellt, welches einen Bestückautomaten 2 und mehrere daran gekoppelte erfindungsgemäße Zuführeinrichtungen 3 aufweist. Der Bestückautomat 2 weist eine Transportstrecke 4 auf, beispielsweise ein Förderband, auf dem zu bestückende Substrate 5 in einer Transportrichtung (Pfeil a) zu einem Bestückplatz 6 des Bestückautomaten 2 transportiert, dort bestückt, und danach wegtransportiert werden. Die Transportstrecke 4 wird von einem Querträger 7 des Bestückautomaten 2 brückenartig überspannt. An dem Querträger 7 ist ein freiragender Trägerarm 8 mittels eines Linearmotors quer zur Transportrichtung (Pfeil b) verschiebbar angebracht. Der Trägerarm 8 hält einen Bestückkopf 9, der an einer Längsseite des Trägerarms parallel zur Transportstrecke 4 (Pfeil a) verschiebbar angeordnet ist und beispielsweise mittels eines weiteren Linearmotors angetrieben wird. Der Bestückkopf 9 ist somit in einer zu einer Bestückfläche der Substrate 5 parallelen Ebene verfahrbar. Der Bestückautomat 2 weist ferner eine Zentralsteuerung 10 auf, welche über elektrische Leitungen (in Figur 1 durch gestrichelte Linien dargestellt) mit dem Bestückkopf 9 verbunden ist. Die Zentralsteuerung 10 ist so ausgebildet, dass sie einen Bestückvorgang des Bestückautomaten 2 steuert und überwacht.

Ferner ist am Bestückautomaten 2 eine Anzeigeeinrichtung 11 angeordnet, welche mit der Steuereinrichtung 12 verbunden ist und über welche Informationen, beispielsweise an einen Maschinenbediener ausgegeben werden können. Seitlich der Transportstrecke 4 sind mehrere erfindungsgemäße Zuführeinrichtungen 3 an dem Bestückautomaten 2 gekoppelt. Jede der Zuführeinrichtungen 3 weist eine Steuereinrichtung 12 auf, welche die internen Abläufe der Zuführeinrichtungen 3 steuert. Das Bestücksystem 1 umfasst eine Datenschnittstelle 13, über welche die Steuereinrichtungen der Zuführeinrichtungen 3 mit der Zentralsteuerung 10 des Bestückautomaten 2 gekoppelt sind und Daten austauschen können. Während eines Bestückvorgangs des Substrats 5 mit elektrischen Bauelementen verfährt der Bestückkopf 9 in einen Abholbereich des Bestückautomaten 2, in dem die Zuführeinrichtungen 3 befinden, entnimmt den Zuführeinrichtungen 3 Bauteile 17, und verfährt zu dem Bestückplatz 6, um dort die Substrate 5 mit den entsprechenden Bauteilen zu bestücken.

Die erfindungsgemäße Zuführeinrichtung 3 eignet sich zum Zuführen und Transportieren von elektrischen Bauteilen, welche in Bauteilgurten gelagert sind. Dazu verfügt die Zuführeinrichtung 3 über einen bekanntermaßen ausgeführten Transportmechanismus.

In Figur 2 ist schematisch ein Querschnitt eines derartigen Bauteilgurts 14 dargestellt. In einem Grundträger 15 des Bauteilgurts 14 sind taschenartige Vertiefungen 16 ausgeformt, in denen die Bauteile 17 gelagert sind. Um ein Herausfallen der Bauteile 17 zu verhindern, ist der Grundträger 15 mit einer Deckfolie 18 abgedeckt.

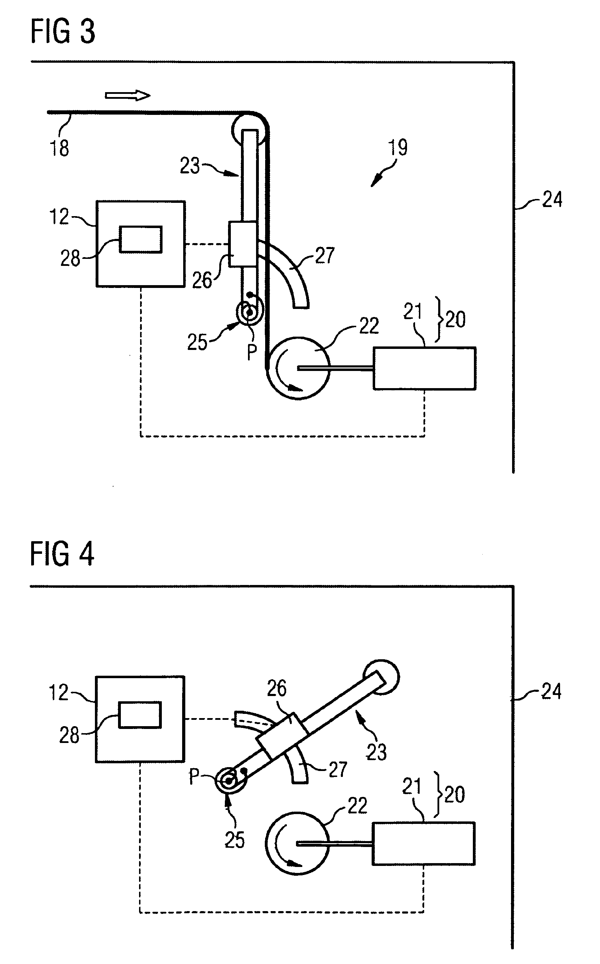

In der Zuführeinrichtung 3 werden die Bauteile 17 zu einer genau definierten Abholposition transportiert, wo sie von dem Bestückkopf 9 aufgenommen werden können. Vor dem Erreichen der Abholposition muss die Deckfolie 18 des Bauteilgurts 14 abgezogen werden, um die Bauelemente freizulegen. Zu diesem Zweck weist die Zuführeinrichtung 3 eine Abzugseinrichtung 19 (siehe Figuren 3 und 4) für die Deckfolie 18 des Bauteilgurts 14 auf. Die Abzugseinrichtung 19 umfasst einen Fördermechanismus 20, welcher beispielsweise als eine von einem Motor 21 angetriebenen Wickelrolle 22, auf der die Deckfolie 18 aufgewickelt wird, ausgeführt sein kann. Ferner umfasst die Zuführeinrichtung 3 ein Spannelement 23, beispielsweise eine federbelastete Schwinge, über die die von der Wickelrolle 22 aufzuwickelnde Deckfolie 18 in einem gespannten Zustand gehalten wird.

Wie aus den Figuren 3 und 4 hervorgeht, ist das Spannelement 23 relativ zu einem Gehäuse 24 der Zuführeinrichtung 3 beweglich bzw. um einen Drehpunkt (P) drehbar gelagert und durch eine Federelement 25, beispielsweise eine Drehfeder, derart vorgespannt (in Figur 3 und 4 im Uhrzeigersinn),dass das Spannelement 23 beim Fehlen einer Deckfolie 18 eine Endlage, wie es beispielsweise in Figur 4 dargestellt ist, einnimmt. Bei Anwesenheit einer Deckfolie 18 befindet sich das Spannelement 23 in einer sich von der Endlage unterscheidenden Spannposition, wie es beispielsweise in Figur 3 dargestellt ist. Die Zuführeinrichtung 3 umfasst ferner einen Sensor 26, mit welchem die Position des Spannelements 23 erfasst werden kann. Im Ausführungsbeispiel ist der Sensor 26 als Hall-Sensor 26 ausgeführt, welcher an dem beweglichen Spannelement 23 vorgesehen ist, und sich zusammen mit dem Spannelement 23 längs einem beispielsweise am Gehäuse 24 montierten Permanentmagneten bewegt, so dass der Sensor 26 je nach Position des Spannelements 23 ein unterschiedliches Signal ausgibt.

Die Steuereinrichtung 12 der Zuführeinrichtung 3 ist mit dem Sensor 26 gekoppelt, so dass der Steuereinrichtung 12 die Information über die Position des Spannelements 23 jederzeit zur Verfügung steht. Ferner ist die Steuereinrichtung 12 auch mit dem Motor 21 des Fördermechanismus 20 für die Deckfolie 18 verbunden.

Wie oben schon erwähnt wurde, nimmt das Spannelement 23 bei Anwesenheit und bei Fehlen einer Deckfolie 18 jeweils unterschiedliche Positionen ein. Die Steuereinrichtung 12 ist derart ausgebildet, dass sie basierend auf der vom Sensor 26 erfassten Position des Spannelements 23 einen Fehlerzustand erkennt. Unter einem Fehlerzustand kann entweder ein Riss, ein Auslaufen oder ein Wechsel des Bauteilgurts 14 (und damit der Deckfolie 18) oder eine sonstige externe Manipulation des Bauteilgurts 14 gemeint sein.

Als eine erste Variante erkennt die Steuereinrichtung 12 den Fehlerzustand dann, wenn sich das Spannelement 23 in der Endlage befindet. In diesem Fall wird der Fehlerzustand sofort bei der Einnahme der Endlage erkannt, was insbesondere dann vorteilhaft ist, wenn ein Fehlerzustand möglichst ohne Zeitverzögerung erkannt werden soll. Während des Betriebs der Zuführeinrichtung 3 kann eine Einnahme der Endlage durch das Spannelement 23 dadurch bedingt sein, dass entweder der Bauteilgurt 14 bzw. die Deckfolie 18 reißt oder der Bauteilgurt 14 bzw. die Deckfolie 18 ausläuft. Im ersten Fall muss der Bauteilgurt 14 nachgeführt und die Deckfolie 18 wieder neu in den Fördermechanismus 20 eingespannt werden. Im zweiten Fall muss ein neuer Bauteilgurt 14 nachgelegt werden.

Eine Einnahme der Endlage durch das Spannelement 23 während des Betriebs kann jedoch auch auftreten, wenn die Wickelrolle 22 durch den Motor 21 für längere Zeit nicht betrieben wird, so dass das Spannelement 23 zur Erhaltung der Spannung der Deckfolie 18 sich immer weiter im Uhrzeigersinn bewegt und schließlich in der Endlage zum Halten kommt. Der Fördermechanismus 20 kann so ausgestaltet sein, dass der Motor 21 zum Nachspannen der Deckfolie 18, beispielsweise durch einen entsprechend angebrachten Schalter, aktiviert wird, wenn das Spannelement 23 die Endlage eingenommen hat. In diesem Fall kann die Steuereinrichtung 12 in einer weiteren Variante derart ausgebildet sein, dass sie den Fehlerzustand erst dann erkennt, wenn sich das Spannelement 23 für eine vorgegebene Zeitdauer in der Endlage befindet. Wird die Zeitdauer überschritten, erkennt die Steuereinrichtung 12 dies als Fehlerzustand, da die Deckfolie 18 aus bestimmten Gründen nicht nachgespannt werden kann.

Die Steuereinrichtung 12 kann alternativ auch derart ausgestaltet sein, dass, wenn die Einnahme der Endlage durch das Spannelement 23 erkannt wird, die Steuereinrichtung 12 den Motor 21 aktiviert, um die überschüssige Deckfolie 18 auf der Wickelrolle 22 aufzuwickeln und dadurch nachzuspannen. Gleichzeitig misst die Steuereinrichtung 12 die Zeit ab dem Start des Motors. Bei Anwesenheit einer Deckfolie 18 würde das Spannelement 23 nach einer gewissen Zeit die Spannposition wieder einnehmen. Wird jedoch die Spanneinrichtung innerhalb einer bestimmten vorgegebenen Zeitdauer nicht eingenommen, so wird von der Steuereinrichtung 12 ein Fehlerzustand erkannt. In den meisten Fällen ist der Fehlerzustand beispielsweise durch einen Riss oder das Auslaufen des Bauteilgurts 14 bzw. Deckfolie 18 bedingt.

Die Steuereinrichtung 12 kann alternativ auch so ausgestaltet sein, dass sich das Kriterium, nach welchem ein Fehlerzustand erkannt wird, danach richtet, ob die Spannposition innerhalb einer gewissen Zeitdauer nach Einnahme der Endlage durch das Spannelement 23 wieder erreicht wird. Wird die von der Endlage unterschiedliche Spannposition nicht innerhalb der vorgegebenen Zeitdauer erreicht, so wird wiederum ein Fehlerzustand erkannt.

Die Steuereinrichtung 12 weist ferner ein nichtflüchtiges Speicherelement 28 auf, in dem Daten dauerhaft abgespeichert werden können. Die Steuereinrichtung 12 kann derart ausgestaltet sein, dass sie vor dem Abschalten der Zuführeinrichtung 3 bzw. dem Trennen der Zuführeinrichtung 3 von einer Spannungsquelle, beispielsweise bei der Entnahme der Zuführeinrichtung 3 vom Bestückautomaten 2, die Position des Spannelements 23 vor dem Abschalten in dem nichtflüchtigen Speicherelement 28 abspeichert. Wird der Bauteilgurt 14 im stromlosen Zustand der Zuführeinrichtung 3 manipuliert, beispielsweise durch einen neuen Bauteilgurt 14 ersetzt, so muss die Zuführeinrichtung 3 nach dem Einlegen des neuen Bauteilgurts 14 zum Spannen der Deckfolie 18 wieder mit Spannung versorgt werden. Nach dem Einschalten vergleicht die Steuereinrichtung 12 die Position des Spannelements 23 beim Einschalten mit der in dem Speicherelement 28 abgespeicherten Position des Spannelements 23 vor dem Abschalten, so dass eine Veränderung der Position sofort erkannt und als Fehlerzustand interpretiert wird.

Aus den obigen Ausführungen wird deutlich, dass durch die erfindungsgemäße Zuführeinrichtung 3 jegliche Arten von Manipulation oder Veränderungen des Bauteilgurts 14 und damit der Deckfolie 18 erkannt und als ein Fehlerzustand interpretiert werden. Dieser Fehlerzustand wird in dem Speicherelement 28 der Steuereinrichtung 12 abgespeichert. Dieser Fehlerzustand wird über die Datenschnittstelle 13 der Zentralsteuerung 10 des Bestückautomaten 2 übertragen. Der Bestückautomat 2 kann daraufhin mehrere Aktionen durchführen.

In einer einfachsten Sicherheitsstufe kann der Bestückautomat 2 dem Maschinenbediener über die Anzeigeeinrichtung 11 mitteilen, dass an der entsprechenden Zuführeinrichtung 3 ein Fehlerzustand aufgetreten ist. Als eine weitere Information kann der Bestückautomat 2 dem Maschinenbediener mitteilen, dass eine erneute Identifikation des Bauteilgurts 14 in der Zuführeinrichtung 3 durchzuführen ist. Die Identifikation des Bauteilgurts 14 geschieht beispielsweise über eine Erfassungseinrichtung 29, wie einem Handscanner, die eine dem Bauteilgurt 14 zugeordnete Markierung, beispielsweise einem Strichcode am Bauteilgurt 14 oder an einem Bauteilgurtgebinde, einliest, so dass die der Zuführeinrichtung 3 entnommenen Bauteile 17 immer genau einem Bauteilgurt 14 zugeordnet und werden können und dadurch ihre Herkunft zurückverfolgt werden kann.

In einer weiteren Sicherheitsstufe kann der Bestückautomat 2 bei Vorliegen eines Fehlerzustands ein Abholen von Bauteilen von der jeweiligen Zuführeinrichtung 3 durch den Bestückkopf 9 unterbinden. Der Bestückprozess kann dabei weitergeführt werden, falls gleichartige Bauteile 17 von anderen Zuführeinrichtungen 3, bei denen kein Fehlerzustand aufgetreten ist, bereitgestellt werden. Alternativ kann der Bestückprozess auch angehalten werden bis der Bauteilgurt 14 der jeweiligen Zuführeinrichtung 3 neu identifiziert wurde. Dadurch wird die Identifizierung des Bauteilgurts 14 erzwungen und die Rückverfolgbarkeit der auf den Substraten verbauten Bauteile 17 lückenlos gewährleistet.

In einer noch weitergehenden Sicherheitsstufe kann die Zentralsteuerung 10 die Identifizierung eines Bauteilgurtes auch automatisch selbst vornehmen, falls die Erfassungseinrichtung 29 derart am Bestückautomat 2 angeordnet ist, dass der Bauteilgurt 14 einer am Bestückautomaten 2 angekoppelten Zuführeinrichtung 3 durch diese Erfassungseinrichtung 29 identifizierbar ist. In dieser Ausgestaltung überlässt das Bestücksystem 1 nicht mehr dem Bediener die Verantwortung über die Identifikation des Bauteilgurts 14, sondern führt diese automatisch selbst durch.

In dem vorher ausgeführten Ausführungsbeispiel ist der Sensor 26 zur Erfassung der Position des Spannelements 23 als Hall-Sensor 26 ausgeführt. Jedoch sind auch entsprechende optische Sensoren oder einfache Schaltelemente, welche in den entsprechenden Positionen (Endlage und Spannposition) des Spannelements 23 angeordnet sind, denkbar. Ferner wird die Deckfolie 18 im Ausführungsbeispiel auf einer Wickelrolle 22 aufgerollt. Genauso ist es jedoch denkbar, dass die Deckfolie 18 nicht gerollt, sondern gestopft wird. Jedoch ist auch in diesem Fall eine mit einem Motor 21 versehene Fördereinrichtung notwendig, so dass der erfindungsgemäße Gedanke analog auch auf eine solche Vorrichtung übertragbar ist.

Bezugszeichenliste:
- 1: Bestücksystem
- 2: Bestückautomat
- 3: Zuführeinrichtung
- 4: Transportstrecke
- 5: Substrat
- 6: Bestückplatz
- 7: Querträger
- 8: Trägerarm
- 9: Bestückkopf
- 10: Zentralsteuerung
- 11: Anzeigeeinrichtung
- 12: Steuereinrichtung
- 13: Datenschnittstelle
- 14: Bauteilgurt
- 15: Grundträger
- 16: Vertiefung
- 17: Bauteile
- 18: Deckfolie
- 19: Abzugseinrichtung
- 20: Fördermechanismus
- 21: Motor
- 22: Wickelrolle
- 23: Spannelement
- 24: Gehäuse
- 25: Federelement
- 26: Sensor
- 27: Permanentmagnet
- 28: Speicherelement
- 29: Erfassungseinrichtung

## Patentansprüche

1. Zuführeinrichtung (3) für elektrische Bauteile (17), welche in einem Bauteilgurt (14) angeordnet sind, mit
- einer Abzugseinrichtung (19) für eine Deckfolie (18) des Bauteilgurts (14),
- einem Spannelement (23) zum Spannen der abgezogenen Deckfolie (18), wobei das Spannelement (23) relativ zu einem Gehäuse (24) der Zuführeinrichtung (3) beweglich gelagert ist und beim Fehlen der Deckfolie (18) eine Endlage einnimmt,
- einem Sensor (26) zum Erfassen der Position des Spannelements (23), und
- einer Steuereinrichtung (12), welche mit dem Sensor (26) verbunden ist und derart ausgebildet ist, dass sie basierend auf der vom Sensor (26) erfassten Position des Spannelements (23) einen Fehlerzustand erkennt,
wobei
- die Abzugseinrichtung (19) einen Fördermechanismus (20) mit einem Motor (21) zum Transport der Deckfolie (18) aufweist,
- das Spannelement (23) eine federbelastete Schwinge aufweist, über die die abgezogene Deckfolie (18) führbar ist,
- das Spannelement (23) bei gespannter Deckfolie (18) eine Spannposition einnimmt,
- der Motor (21) mit der Steuereinrichtung (12) verbunden ist, und **dadurch gekennzeichnet, dass**
- die Steuereinrichtung (12) den Fehlerzustand dann erkennt, wenn das Spannelement (23) nach Einschalten des Motors, welches durch die Steuereinrichtung (12) erfassbar ist, nicht innerhalb einer vorgegebenen Zeitdauer die Spannposition einnimmt.

2. Zuführeinrichtung (3) nach Anspruch 1, wobei die Steuereinrichtung (12) den Fehlerzustand dann erkennt, wenn sich das Spannelement (23) in der Endlage befindet.

3. Zuführeinrichtung (3) nach Anspruch 1, wobei die Steuereinrichtung (12) den Fehlerzustand dann erkennt, wenn sich das Spannelement (23) für eine vorgegebene Zeitdauer in der Endlage befindet.

4. Zuführeinrichtung (3) nach Anspruch 1, wobei der Sensor derart ausgebildet ist, dass er zumindest die Spannposition und die Endlage des Spannelements erfasst, und wobei die Steuereinrichtung (12) den Fehlerzustand dann erkennt, wenn das Spannelement (23) nach Einnahme der Endlage nicht innerhalb einer vorgegebenen Zeitdauer die Spannposition einnimmt.

5. Zuführeinrichtung (3) nach einem der Ansprüche 1 bis 4, wobei der Sensor (26) als Hallsensor ausgebildet ist.

6. Steuerverfahren für eine Zuführeinrichtung (3) für in einem Bauteilgurt (14) angeordnete elektrische Bauteile (17), welche Zuführeinrichtung (3) aufweist
- eine Abzugseinrichtung (19) für eine Deckfolie (18) des Bauteilgurts (14),
- ein Spannelement (23) zum Spannen der abgezogenen Deckfolie (18), wobei das Spannelement (23) relativ zu einem Gehäuse (24) der Zuführeinrichtung (3) beweglich gelagert ist und beim Fehlen der Deckfolie (18) eine Endlage einnimmt,
- einen Sensor (26) zum Erfassen der Position des Spannelements (23),
- eine Steuereinrichtung (12), welche mit dem Sensor (26) verbunden ist und derart ausgebildet ist, dass sie basierend auf der vom Sensor (26) erfassten Position des Spannelements (23) einen Fehlerzustand erkennt,
- die Abzugseinrichtung (19) einen Fördermechanismus (20) mit einem Motor (21) zum Transport der Deckfolie (18) aufweist,
- das Spannelement (23) eine federbelastete Schwinge aufweist, über die die abgezogener Deckfolie (18) führbar ist, .
- das Spannelement (23) bei gespannter Deckfolie (18) eine Spannposition einnimmt,
- der Motor (21) mit der Steuereinrichtung (12) verbunden ist, und
- die Steuereinrichtung (12) den Fehlerzustand dann erkannt, wenn das Spannelement (23) nach Einschalten des Motors, welches durch die Steuereinrichtung (12) erfassbar ist, nicht innerhalb einer vorgegebenen Zeitdauer die Spannposition einnimmt, und
- ein nichtflüchtiges Speicherelement (28), welches mit
der Steuereinrichtung (12) verbunden ist,
wobei
die Steuereinrichtung (12) vor jedem Abschalten der Zuführeinrichtung (3) die Position des Spannelements (23) in dem Speicherelement (28) abspeichert und diese mit der Position des Spannelements (23) beim darauf folgenden Einschalten der Zuführeinrichtung (3) vergleicht, und die Steuereinrichtung (12) den Fehlerzustand dann erkennt, wenn sich die beiden Positionen unterscheiden.

7. Steuerverfahren nach Anspruch 6, wobei die Steuereinrichtung (12) den Fehlerzustand in dem Speicherelement (28) abspeichert.

8. Steuerverfahren nach Anspruch 6 oder 7,
wobei
die Zuführeinrichtung an einen Bestückautomaten gekoppelt ist und eine Datenschnittstelle (13), über welche Daten zwischen der Steuereinrichtung (12) der Zuführeinrichtung (3) und einer dem Bestückautomaten (2) zugeordneten Zentralsteuerung (10) austauschbar sind, aufweist,
wobei
die Steuereinrichtung (12) den Fehlerzustand an die Zentralsteuerung (10) übermittelt.

9. Steuerverfahren nach Anspruch 8, wobei die Zentralsteuerung (10) des Bestückautomaten (2) den Fehlerzustand über eine Anzeigeeinrichtung (11) anzeigt.

10. Steuerverfahren nach einem der Ansprüche 8 bis 9, wobei die Zentralsteuerung (10) vor dem Abholen eines Bauteils von der Zuführeinrichtung (3) mittels eines Bestückkopfs des Bestückautomaten (2) prüft ob der Fehlerzustand erkannt wurde, und der Bestückautomat (2) keine Bauteile (17) von der Zuführeinrichtung (3) abholt, falls der Fehlerzustand erkannt wurde.

11. Steuerverfahren nach Anspruch 10, wobei der von der Zuführeinrichtung (3) zu fördernde Bauteilgurt (14) mittels einer ihm zugeordneten Markierung von einer Erfassungseinrichtung (29) identifizierbar ist und der Bestückautomat (2) erst dann wieder Bauteile (17) von der Zuführeinrichtung (3) abholt, nachdem der Bauteilgurt (14) von der Erfassungseinrichtung (29) identifiziert wurde.

12. Steuerverfahren nach Anspruch 11, wobei die Erfassungseinrichtung (29) mit der Zentralsteuerung (10) verbunden und derart an dem Bestückautomat (2) angeordnet ist, dass der in der Zuführeinrichtung (3) eingelegte Bauteilgurt (14) identifizierbar ist, und wobei die Zentralsteuerung (10) die Identifizierung automatisch durchführt, wenn der Fehlerzustand erkannt wurde.

## Claims

1. Feeder device (3) for electrical components (17) arranged in a component belt (14), having
- a removal device (19) for a covering film (18) of the component belt (14),
- a tensioner (23) for tensioning the removed covering film (18), the tensioner (23) being mounted so as to be movable relative to a housing (24) of the feeder device (3) and assuming a stop position in the absence of the covering film (18),
- a sensor (26) for recording the position of the tensioner (23), and
- a control device (12) which is connected to the sensor (26) and is designed such that it recognises an error status on the basis of the position of the tensioner (23) recorded by the sensor (26),
wherein
- the removal device (19) has a transport mechanism (20) with a motor (21) to transport the covering film (18),
- the tensioner (23) has a spring-loaded rocker arm via which the removed covering film (18) can be guided,
- the tensioner (23) assumes a tensioning position when the covering film (18) is tensioned,
- the motor (21) is connected to the control device (12),
**characterised in that**
- the control device (12) recognises the error status if the tensioner (23) does not assume the tensioning position within a predefined period of time after the motor has been switched on, which can be recorded by the control device (12).

2. Feeder device (3) according to claim 1, the control device (12) recognising the error status if the tensioner (23) is in the stop position.

3. Feeder device (3) according to claim 1, the control device (12) recognising the error status if the tensioner (23) is in the stop position for a predefined period of time.

4. Feeder device (3) according to claim 1, the sensor being designed such that it at least records the tensioning position and the stop position of the tensioner, and the control device (12) recognising the error status if the tensioner (23) does not assume the tensioning position within a predefined period of time after assuming the stop position.

5. Feeder device (3) according to one of claims 1 to 4, the sensor (26) being designed as a Hall sensor.

6. Control method for a feeder device (3) for electrical components (17) arranged in a component belt (14), said feeder device (3) having
- a removal device (19) for a covering film (18) of the component belt (14),
- a tensioner (23) for tensioning the removed covering film (18), the tensioner (23) being mounted so as to be movable relative to a housing (24) of the feeder device (3) and assuming a stop position in the absence of the covering film (18),
- a sensor (26) for recording the position of the tensioner (23), and
- a control device (12) which is connected to the sensor (26) and is designed such that it recognises an error status on the basis of the position of the tensioner (23) recorded by the sensor (26),
- the removal device (19) having a transport mechanism (20) with a motor (21) to transport the covering film (18),
- the tensioner (23) having a spring-loaded rocker arm via which the removed covering film (18) can be guided,
- the tensioner (23) assuming a tensioning position when the covering film (18) is tensioned.
- the motor (21) being connected to the control device (12), and
- the control device (12) recognising the error status if the tensioner (23) does not assume the tensioning position within a predefined period of time after the motor has been switched on, which can be recorded by the control device (12), and
- a non-volatile memory element (28) which is connected to the control device (12),
wherein
the control device stores the position of the tensioner (23) in the memory element (28) each time the feeder device (3) is switched off and compares it with the position of the tensioner (23) when the feeder device (3) is subsequently switched on, and the control device (12) recognises the error status if the two positions differ from one another.

7. Control method according to claim 6, the control device (12) storing the error status in the memory element (28).

8. Control method according to claim 6 or 7,
wherein
the feeder device is linked to a pick-and-place machine and a data interface (13), via which data can be exchanged between the control device (12) of the feeder device (3) and a central controller (10) assigned to the pick-and-place machine (2),
wherein
the control device (12) transmits the error status to the central controller (11).

9. Control method according to claim 8, the central controller (10) of the pick-and-place machine (2) displaying the error status via a display device (11).

10. Control method according to one of claims 8 to 9, the central controller (10) checking, before picking a component from the feeder device (3) by means of a fitting head of the pick-and-place machine (2), whether the error status was recognised, and the pick-and-place machine (2) not picking any components (17) from the feeder device (3) if the error status was recognised.

11. Control method according to claim 10, the component belt (14) to be transported by the feeder device (3) being identifiable by means of a marking assigned to it by a recording device (29) and the pick-and-place machine (2) not picking components (17) from the feeder device (3) again until the component belt (14) has been identified by the recording device (29).

12. Control method according to claim 11, the recording device (29) being connected to the central controller (10) and arranged on the pick-and-place machine (2) such that the component belt (14) inserted into the feeder device (3) is identifiable, and the central controller (10) automatically performing the identification if the error status was recognised.

## Revendications

1. Dispositif d'alimentation (3) pour des composants électriques (17) disposés dans une bande pour composants (14), comprenant
- un dispositif d'extraction (19) pour une feuille de recouvrement (18) de la bande pour composants (14),
- un élément de tension (23) destiné à tendre la feuille de recouvrement (18) retirée, l'élément de tension (23) étant logé de manière mobile par rapport à un boîtier (24) du dispositif d'alimentation (3) et prenant une position finale lorsque la feuille de recouvrement (18) fait défaut,
- un capteur (26) destiné à détecter la position de l'élément de tension (23), et
- un dispositif de commande (12) qui est raccordé au capteur (26) et est exécuté de telle manière que, sur la base de la position de l'élément de tension (23) détectée par le capteur (26), il identifie un état d'erreur,
- le dispositif d'extraction (19) présentant un mécanisme transporteur (20) comprenant un moteur (21) pour le transport de la feuille de recouvrement (18),
- l'élément de tension (23) présentant une bielle oscillante contrainte par ressort, par l'intermédiaire de laquelle la feuille de recouvrement (18) retirée peut être guidée,
- l'élément de tension (23) prenant une position de tension lorsque la feuille de recouvrement (18) est tendue,
- le moteur (21) étant raccordé au dispositif de commande (12), et **caractérisé en ce que**
- le dispositif de commande (12) identifie l'état d'erreur lorsque l'élément de tension (23), après la mise en marche du moteur, lequel élément de tension est identifiable au moyen du dispositif de commande (12), ne prend pas la position de tension dans un temps prédéfini.

2. Dispositif d'alimentation (3) selon la revendication 1, le dispositif de commande (12) identifiant l'état d'erreur lorsque l'élément de tension (23) se trouve dans la position finale.

3. Dispositif d'alimentation (3) selon la revendication 1, le dispositif de commande (12) identifiant l'état d'erreur lorsque l'élément de tension (23) se trouve dans la position finale pendant un temps prédéfini.

4. Dispositif d'alimentation (3) selon la revendication 1, le capteur étant exécuté de telle manière qu'il détecte au moins la position de tension et la position finale de l'élément de tension, et le dispositif de commande (12) identifiant l'état d'erreur lorsque l'élément de tension (23), après avoir pris la position finale, ne prend pas la position de tension dans un temps prédéfini.

5. Dispositif d'alimentation (3) selon l'une quelconque des revendications 1 à 4, le capteur (26) étant exécuté comme capteur de Hall.

6. Procédé de commande pour un dispositif d'alimentation (3) pour des composants électriques (17) disposés dans une bande pour composants (14), lequel dispositif d'alimentation (3) présente
- un dispositif d'extraction (19) pour une feuille de recouvrement (18) de la bande pour composants (14),
- un élément de tension (23) destiné à tendre la feuille de recouvrement (18) retirée, l'élément de tension (23) étant logé de manière mobile par rapport à un boîtier (24) du dispositif d'alimentation (3) et prenant une position finale lorsque la feuille de recouvrement (18) fait défaut,
- un capteur (26) destiné à détecter la position de l'élément de tension (23), et
- un dispositif de commande (12) qui est raccordé au capteur (26) et est exécuté de telle manière que, sur la base de la position de l'élément de tension (23) détectée par le capteur (26), il identifie un état d'erreur,
- le dispositif d'extraction (19) présentant un mécanisme transporteur (20) comprenant un moteur (21) pour le transport de la feuille de recouvrement (18),
- l'élément de tension (23) présentant une bielle oscillante contrainte par ressort, par l'intermédiaire de laquelle la feuille de recouvrement (18) retirée peut être guidée,
- l'élément de tension (23) prenant une position de tension lorsque la feuille de recouvrement (18) est tendue,
- le moteur (21) étant raccordé au dispositif de commande (12) et
- le dispositif de commande (12) identifiant l'état d'erreur lorsque l'élément de tension (23), après la mise en marche du moteur, lequel élément de tension est identifiable au moyen du dispositif de commande (12), ne prend pas la position de tension dans un temps prédéfini, et
- un élément de mémoire (28) non volatil, lequel est raccordé au dispositif de commande (12),
- le dispositif de commande (12) mémorisant dans l'élément de mémoire (28) la position de l'élément de tension (23) avant chaque arrêt du dispositif d'alimentation (3) et comparant celle-ci à la position de l'élément de tension (23) lors de la mise en marche suivante du dispositif d'alimentation (3), et le dispositif de commande (12) identifiant l'état d'erreur lorsque les deux positions se distinguent l'une de l'autre.

7. Procédé de commande selon la revendication 6, le dispositif de commande (12) mémorisant l'état d'erreur dans l'élément de mémoire (28).

8. Procédé de commande selon la revendication 6 ou 7,
le dispositif d'alimentation étant couplé à un automate d'équipement et présentant une interface de données (13) par l'intermédiaire de laquelle des données sont échangeables entre le dispositif de commande (12) du dispositif d'alimentation (3) et une commande centrale (10) associée à l'automate d'équipement (2),
le dispositif de commande (12) transmettant l'état d'erreur à la commande centrale (10).

9. Procédé de commande selon la revendication 8, la commande centrale (10) de l'automate d'équipement (2) indiquant l'état d'erreur par l'intermédiaire d'un dispositif d'affichage (11).

10. Procédé de commande selon l'une quelconque des revendications 8 à 9, la commande centrale (10) vérifiant, avant le prélèvement d'un composant sur le dispositif d'alimentation (3) au moyen d'une tête d'équipement de l'automate d'équipement (2), si l'état d'erreur a été identifié, et l'automate d'équipement (2) ne prélevant pas de composants (17) du dispositif d'alimentation (3) au cas où l'état d'erreur ait été identifié.

11. Procédé de commande selon la revendication 10, la bande pour composants (14) à transporter par le dispositif d'alimentation (3) étant identifiable par un dispositif de détection (29) au moyen d'une marque correspondant à la bande pour composants et l'automate d'équipement (2) prélevant de nouveau des composants (17) du dispositif d'alimentation (3) seulement après que la bande pour composants (14) ait été identifiée par le dispositif de détection (29).

12. Procédé de commande selon la revendication 11, le dispositif de détection (29) étant raccordé à la commande centrale (10) et étant disposé de telle manière sur l'automate d'équipement (2) que la bande pour composants (14) posée dans le dispositif d'alimentation (3) est identifiable, et la commande centrale (10) exécutant l'identification automatiquement lorsque l'état d'erreur a été identifié.
